# EUROPEAN PATENT SPECIFICATION

(11) **EP 3 566 249 B1**
(45) Date of publication and mention of the grant of the patent: **29.11.2023**
(21) Application number: 18701969.0
(22) Date of filing: 05.01.2018
(51) Int. Cl.: H01L 31/0224, H01L 31/0304, H01L 31/108, H01L 31/109

(54) **EXTREME AND DEEP ULTRAVIOLET PHOTOVOLTAIC CELL**
EXTREM- UND TIEF-ULTRAVIOLETTE FOTOVOLTAISCHE ZELLE
CELLULE PHOTOVOLTAÏQUE À ULTRAVIOLETS EXTRÊMES ET PROFONDS

(30) Priority: 05.01.2017 US 201762442847 P
(43) Date of publication of application: 13.11.2019
(73) Proprietor: Brilliant Light Power, Inc., Cranbury, NJ 08512 (US)
(72) Inventor: MILLS, Randell, L., Coatesville PA 19320 (US); DOOLITTLE, William, Hampton GA 30228 (US)
(74) Representative: Uexküll & Stolberg
(86) International application number: PCT/US2018/012635
(87) International publication number: WO 2018/129353

(56) References cited:
- EP-A1- 2 400 558
- US-A1- 2008 245 400

## Description

### CROSS-REFERENCES OF RELATED APPLICATIONS

This application claims the benefit of U.S. Provisional Application No. 62/442,847, filed January 5, 2017.

### SUMMARY OF THE DISCLOSURE

The present disclosure relates to the field of extreme and deep ultra-violet photovoltaic devices designed to efficiently convert extreme ultra-violet (EUV) and deep ultra violet (DUV) photons originating from an EUV/DUV power source to electrical power. More specifically, embodiments of the present disclosure are directed to power conversion devices and systems, which produce electrical power via the absorption of photons creating electrons and holes that are subsequently separated via an electric field so as to create a voltage that can drive power in an external circuit. Unlike traditional solar cells, the absorption of the extreme/deep ultra-violet light near the surface of the device requires special structures constructed from large and ultra-large bandgap semiconductors so as to maximize converted power, eliminate absorption losses and provide the needed mechanical integrity.

The present disclosure is directed to a photovoltaic device according to appended claim 1. The appended dependent claims refer to optional features of the invention.

### BRIEF DESCRIPTION OF THE DRAWINGS

The accompanying drawings, which are incorporated in and constitute a part of this specification, illustrate several embodiments of the disclosure and together with the description, serve to explain the principles of the disclosure. In the drawings:
Figure 1 shows a comparison of the extreme and deep ultraviolet spectrums of Brilliant Light Power's SunCell^{®} power source to that of the solar spectrums in space (AMO) and terrestrial spectrums (AM1.5).
Figure 2 shows a spectral response curve of a real solar cell compared to that of an ideal solar cell showing near zero response in the EUV, DUV and even UV spectral regions.
Figure 3 shows a reflectance spectra of a 300 nm thick layer of aluminum which indicates a transparency window for photons above about 15 eV (wavelengths less than ~82 nm).
Figure 4 shows transmission data for various metals as a function of wavelength.
Figure 5 shows the cross section of the grown semiconductor stack on the substrate.
Figure 6A shows the cross section and Figure 6B shows the top view from the CAD photolithography mask model showing the device stack after etching to expose the buried base and to electrically isolate the junction.
Figure 7A shows the cross section and Figure 7B shows the top view from the CAD photolithography mask model showing the added base metallization for the embodiments that use a non-conductive substrate.
Figure 8A shows the cross section and Figure 8B shows the top view from the CAD photolithography mask model showing the added current spreading layers for those embodiments that use an enhanced lateral contact layer.
Figure 9A shows the cross section and Figure 9B shows the top view from the CAD photolithography mask model showing the added emitter metallization for the embodiments that use a non-conductive substrate and a current spreading layer.
Figure 10A shows the cross section and Figure 10B shows the top view from the CAD photolithography mask model showing the added base metallization on the backside of the substrate for the embodiments that use a conductive substrate.
Figure 11 shows a comparison of DC current voltage characteristics of several diodes with differing emitter structures ranging from 5, 10, 20 and 50 nm p-type GaN to 50 nm p-type AlGaN as well as a typical GaN LED for reference.
Figure 12 shows a comparison of two inverted structures with a p-type GaN base and an n-type GaN emitter, wherein only the base doping is changed in the two curves.
Figure 13 shows the DC current voltage characteristics of a 2DHG enhanced heterostructure diode indicating negative differential resistance after the first measurement, with a GaN LED included for comparison.
Figure 14 shows a comparison of near ideal aluminum metal GaN Schottky diode current voltage characteristic with that from an otherwise identical aluminum metal AlGaN Schottky diode.
Figure 15 shows a schematic of the transient DUV power source, Brilliant Light Power's SunCell^{®} power source.
Figure 16 shows a representative spectrum resulting from Brilliant Light Power's SunCell^{®} power source in arbitrary units with a dashed line indicating the onset of substantial air absorption at small wavelengths.

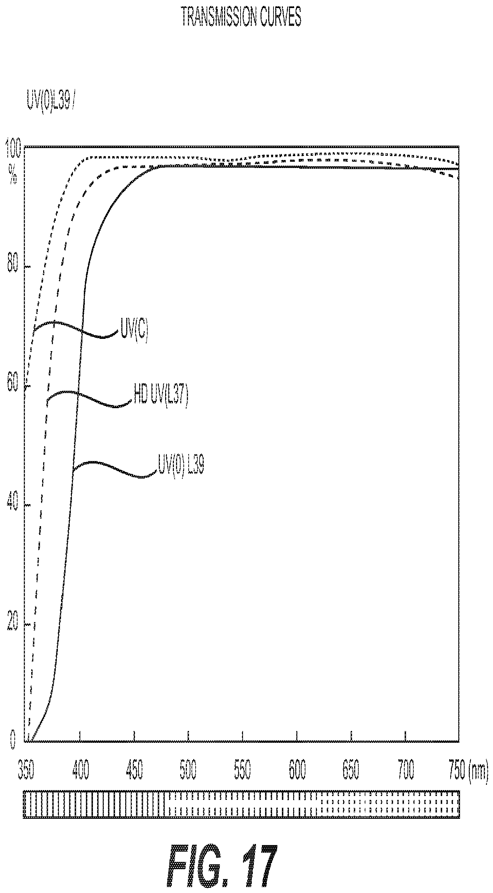

Figure 17 shows the spectral transmission for the HOYA UV(0) filter showing a cutoff of 400 nm (onset of the UV range).
Figure 18 shows a schematic of the constant flux deuterium lamp test apparatus.
Figure 19 shows the spectral power of the deuterium lamp used for constant flux tests.
Figure 20 shows experimental results for several embodiments demonstrating the transient photovoltage for Brilliant Light Power's SunCell^{®} power source having a spectral content as described by Figure 16.

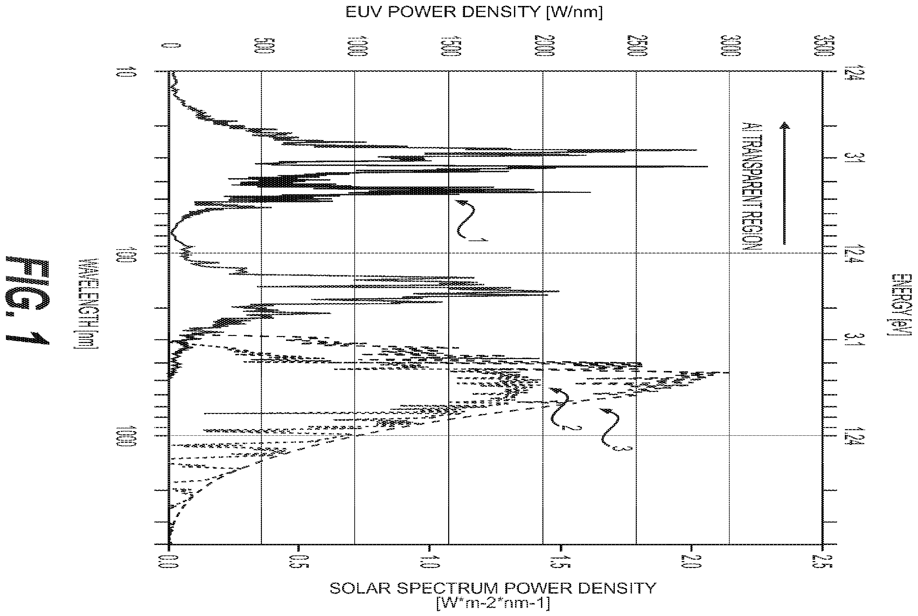

Solar cells are well known and common devices for the conversion of solar energy originating from the sun or similar thermal light source to electrical power. Solar cells convert power from the sun into electrical energy. The solar spectrum is very closely approximated by a black body radiator of operating temperature of about 5762 ± 50 K. The solar spectrum of light converted into power by a solar cell is shown in figure 1 and is compared to the spectrum of a prototypical deep/extreme ultraviolet light source spectrum. As shown in figure 1, the 1 EUV spectrum has little overlap in the optical power with either the 2 global AM1.5 spectra (terrestrial spectra accounting for atmospheric absorption) or the 3 space spectra AM0. Specifically, the EUV light source spectra ranges from ~10 nm and falls to zero at wavelengths around 300-350 nm where the solar spectrum begins to increase power. The solar spectrum has maximum spectral power density in the visible light range. The EUV spectrum has two maxima in the deep and extreme UV wavelength ranges. The difference in the EUV and solar spectrums (space or terrestrial) results in almost zero power conversion when attempting to use a traditional solar cell in combination with a EUV power source. In contrast, the EUV photovoltaic device of the present disclosure are able to maximize power conversion.

Solar cells operate based on several physical steps that lead to a created voltage which can drive current through an external circuit, thus performing work. These steps generally are: 1) light hitting the solar cell, 2) absorbing Light and generating electrical carriers known in the art as electrons and holes, 3) diffusion of electrons and holes, 4) collection or "physical separation" (often just described as "separation") of the electrons and holes to create a voltage and 5) driving current into solar cell metal wires and external wiring. Each of these processes also occurs in the EUV Photovoltaic cell but the EUV spectrum and resulting unique physics result in the present disclosure incorporating a substantially different EUV PV cell design. The physics of a traditional solar cell are first described followed by a description of the differences in traditional solar cells compared to the photovoltaic devices of the present disclosure.

Traditional solar cells are designed to limit optical reflection. Since the wavelengths of light in a traditional solar cell are reasonably long, most solar cells utilize a variety of geometric optics techniques to minimize reflections. These include alternating layers of higher and lower index of refraction dielectric layers that form an anti-reflection coating. Often the solar cell surface is intentionally roughened, or "textured", in either a planned or random way so as to provide for more than one opportunity to couple the light into the semiconductor material. By having the light hit the "textured surface", any solar photon reflected on an initial contact with the semiconductor can be reflected toward another part of the semiconductor and have a second or more opportunity to be transmitted into the semiconductor.

Solar cells are made of fairly brittle materials that are subject to mechanical damage. For this reason, they are placed under a "cover glass" to mechanically and chemically (mostly water corrosion) protect the devices from their environment.

Solar cells often focus on the back contact as it is a significant loss of power. Specifically, the solar light is dominated by long wavelength photons that are often poorly absorbed in the semiconductor.

Thus, full metal back coverage can be used as a mirror to give non-absorbed photons a "second chance" to be absorbed. Unfortunately, while this helps with the optical absorption by providing effectively twice as much optical path length for which the photon can be absorbed, the metal enhances a power loss mechanism known as electron-hole-pair recombination described later.

The semiconductors used for solar cells have a property known as the "energy bandgap" that greatly affects the power conversion efficiency. The energy bandgap defined in simplest terms relative to the solar cell discussion is simply the energy required to break a valence electron (an electron located in the outermost atomic levels) off the atom and have it freely conduct throughout the semiconductor. This free conduction electron is often just referred to as "an electron". After the electron is broken off the atom's valence shell, an empty "state" exists in the valence shell, known as a hole. This "hole" allows the neighboring valence electrons to jump into its hole, thus allowing the hole to move in an analogous manner to the free conduction electron. For these reasons, the electrons and holes are considered the "carriers of electricity" in a solar cell, or simply referred to as "carriers". Often since the electron and hole are created in the same photon absorption process, they are referred to as an electron-hole pair.

This energy bandgap also results in a series of design trade-offs when maximum electrical power is desired. Specifically, the energy bandgap corresponds to the minimum photon energy that can be absorbed in the semiconductor via mechanisms that can be used to convert optical power to electrical power. The energy bandgap also corresponds to the electrical potential energy that can be collected from a single photon. Any excess energy above that energy bandgap/potential energy is lost as kinetic energy imparted to the electrons and holes created during the absorption process. Only the potential energy can be collected as power.

The energy/wavelength of the light also determines where in the solar cell the photon is absorbed and thus where in the solar cell the electron-hole pair is created when the atoms valence electron is broken off the atom. Higher energy (shorter wavelength) photons are absorbed closer to the front (light incident side) of the device while longer wavelength (lower energy) photons are absorbed deeper (further away from the light incident side) in the device.

Recombination is the major power loss mechanism within a solar cell. Recombination is the process by which a previously photogenerated electron interacts with and combines with a previously photogenerated hole. When these electrons and holes recombine, the potential energy gained from the photogeneration is lost to thermal energy or photon reemission. Recombination events can result from the random collision of electron-hole pairs, via a defect that first captures the electron (or hole) then the hole (or electron). Defects enhance recombination by increasing the probability of recombination since one of the two particles is relatively stationary (stationary due to the carrier orbiting a defective region in the semiconductor or being captured by an available state or broken semiconductor bond). Defects can be "point defects" (missing or extra atoms), "line defects" (dislocations), and planar defects (stacking faults, grain boundaries, and surfaces). The bigger the defect, the larger the probability of recombination as quantified by a capture cross section and thus the more power is lost.

Some defects, specifically surfaces, have such a large impact on recombination and power conversion loss that they are characterized not only by a capture cross section but by the rate at which carriers flow toward the surface, a surface recombination velocity. Surfaces are important to the present disclosure. Since the light absorbed in the semiconductor creates a sea of photogenerated carriers, the recombination around defects, surfaces specifically, creates drains that result in a flow of carriers toward the defect. The stronger the recombination of a defect, the faster the carriers flow to the defect resulting in a large recombination velocity. Surfaces are thus characterized by a surface recombination velocity (SRV).

The electrons and holes can be classified as minority or majority carriers. In an n-type material, electrons are the majority carrier and holes are the minority carrier. In a p-type material, holes are the majority carrier and electrons are the minority carrier. Under low light conditions (normal "1-sun illumination" for example) the minority carriers determine the collected current. Under magnified illumination depending on the doping concentrations in the semiconductor, a condition known as "high level injection" can be reached wherein both the minority and majority carriers are approximately equivalent in concentration and thus, both contribute to the photocurrent.

Semiconductors have a critical property for solar cells known as the "minority carrier diffusion length" which is related mathematically to the "minority carrier lifetime". These properties are the average distance a minority carrier travels and the average time it takes in that travel before it will recombine. Experts in the art recognize that the minority carrier diffusion length should be maximized for good photovoltaic energy conversion. However, the minority carrier diffusion length (through the impact of the minority carrier lifetime) is strongly affected by defects, particularly the surfaces. For this reason, often solar cells include a surface dielectric or other coating or semiconductor layer to reduce the number of electrically active (capable of recombining carriers) defects, thus reducing the surface recombination velocity.

Contacts to remove current from the semiconductor represent extremely detrimental defects that can effectively recombine carriers. This is because "ohmic contact" metal contacts kill off minority carriers and only pass majority carriers. Thus, in normal solar cells, for this reason and the reasons of shadowing the illuminated regions, the area of the metallization is minimized.

Photogenerated carriers are always created in equal numbers distributed between negative carriers, electrons, and positive carriers, holes. Thus, unless the electrons and holes are separated from each other, no net charge/voltage is available. For this reason, a solar cell requires the presence of an internal force that can separate carriers and thus produce a voltage (separated charge) which can be used to drive current in an external circuit. Most always, this internal force is an internal electric field that can separate the electron from the hole to create a voltage. The polarity of the electric field is arranged so as to drive electrons toward the cathode and holes toward the anode creating a positive voltage on the anode relative to the cathode.

As described above, metal "ohmic contacts" only carry majority carriers meaning that any minority carriers that reach the contacts recombine and are lost. The current flowing through the metal layers attached to the semiconductor are thus driven into the metals by the photoinduced voltage described above. The size of the metal wires needs to be large enough to minimize resistance losses as the current flows but small enough to minimize illumination shadowing losses and recombination losses as described above. In many solar cells, a transparent conducting layer (TCL, typically a wide bandgap semiconductor) is used on the illuminated side so as to allow better lateral conduction, minimizing resistance losses while still maintaining optically transparent windows allowing the light to be absorbed in the solar cell. Typically these transparent conducting layers are wider bandgap semiconductors that are transparent to the solar spectrum. In the case of the solar cell using a transparent conducting layer, the metal contacts are on the transparent conducting layer instead of directly on the semiconductor. Contacts are a major source of series resistance power losses, and long term failure.

While there are several patents that mention the use of III-Nitrides in traditional solar cell devices, there is no known patent or literature reference teaching design or demonstration of a DUV/EUV PV cell. All known references are for solar spectrum devices not EUV/DUV PV cells, with the overwhelming majority of patents involving InGaN low/moderate bandgap materials compatible with the solar spectrum but not AlN or AlGaN which is compatible with the EUV/DUV spectra. The only exceptions being EP 2828897 A1 and related US 9219173 B2 which covers "AlN and AlGaN emitters". These patents focus on using high bandgap materials for solar spectrum transparent front surface fields to be used in an "induced junction" solar cell, specifically in silicon. Induced junction solar cells use the electric field from a surface charge or in this case, a heterojunction to separate the photocurrent to produce voltage. Thus, this patent is focused on deeper absorbing solar photons that are separated by an induced junction that results from the heterojunction and thus, not relevant to the present disclosure.

The first solar cell patent to use III-Nitrides is believed to be US 4139858, which discloses GaN as a transparent conductive electrode to reduce shadow loss and as a cap for concentrator cell possibilities. US 6447938 B1 does the same with GaN as a transparent conductive electrode to reduce shadow loss and as a cap for concentrator cell possibilities. US 2005/0211291 A1 discloses a multi-junction solar cell assembly with a transparent substrate and a varying In and Ga content and thickness for each junction. They used AlN and GaN as a superlattice to reduce the defect density but did not use either binary compound as any part of the active region. WO 2013/043249 A1 discloses an Al base anodized to form Al₂O₃ then added an InN layer, then InGaN layer, then InAlGaN layer, then AlN layer all deposited by CVD. US7968793 B2 discloses a nanoparticle solar cell with p-type AlGaN:Mg, AlGaN:H, or AlGaAs. The n-type layer is nanoparticles not films as in the present disclosure. The N-type contact is transparent conductive carbon nanotubes or oxide layer which would be incompatible with the EUV/DUV spectra. US 6355874 B1 discloses a single solar cell and double tandem solar cell made with low bandgap versions of AlGaInN that are not compatible with the EUV/DUV spectrums.

Solar cells that include GaN but are substantially different in design and application to the present disclosure include: US 2010/0282304 A1 discloses GaN solar cell and a bifunctional device with a controller to select if the material acts as a solar cell or LED. US 2015/0349159 A1 discloses a bendable four-sided nanostructure solar cell that might include GaN. US 2014/0090688 A1 discloses III-Nitride multi-junction solar cells with light coming through the substrate and high to lower bandgap from the substrate up. US 8609456 B2 discloses forming a textured GaN or InN layer on a textured substrate, depositing a metal on the growth semiconductor, then separating the semiconductor and metal from the substrate.

The following disclose Al containing III-Nitride semiconductors but focus on the low to moderate bandgap solar spectrum compatible alloys, not the high bandgap EUV /DUV compatible alloys. US 2010/0095998 A1 discloses InAlN and InGaN multi-junction cells using tunnel junctions. US 9373734 B1 discloses InGaN, InAlN and InGaAlN "powder" blended with other materials. US 2009/0173373 A1 discloses a compositionally graded InGaN or InAlN solar cell with the possibility of multijunction cells using tunnel junction interconnects.

Several patents and publications disclose the use of InGaN which has too small of a bandgap to be effective for the EUV/DUV spectra. The following are patents and publications involving InGaN or InN low/modest bandgap materials: US2013/0074907 A1 and US 9147701 B2 disclose a monolithic InGaN solar cell with an integrated dc converter. CN103022257 B is a regular pin InGaN solar cell with the intrinsic region being InGaN with p GaN cap. CN103022211 B is similar to CN103022257 B but discloses the aid of a polarization gradient. CN 102832272 B discloses a pn InGaN solar cell with GaN cap specifically grown at 700-800 °C and with a thickness of only 5-10nm. CN 103151416 B further discloses an InGaN solar cell laser-lifted off and bonded to a metal reflector with the InGaN surface roughened for light trapping. CN 102315291 A discloses a superlattice to reduce defect density. CN 204391128 U discloses a pin InGaN solar cell with specific thicknesses and an anti reflection film that is not compatible with the EUV /DUV spectra. US 7217882 B2 discloses a multi-junction solar cell with pn InGaN layers for each junction and Tunnel Junction interconnects. CN 200610098234 discloses an InGaN solar cell with an added battery. US2008/0276989 A1 discloses a flipped chip solar cell where III-N layer is stacked onto another substrate such as Si since growing directly on the alternative substrates can be difficult. US 9171990 B2 discloses another flip chip stacking patent targeting the solar spectrum not the EUV/DUV. CN 101101933 A discloses a generic multi-junction InGaN solar cell with homojunction collectors and tunnel junction interconnects solar irradiated through the sapphire backside. US 8138410 B2 discloses a generic tandem solar cell with lower bandgap cells underneath "higher" bandgap cells including InGaN. All these bandgaps are too low to be compatible with the EUV/DUV spectra. US 2011/0308607 A1 discloses a III-Nitride cell on a silicon substrate. CN 201754407 U discloses an InGaN solar cell with InGaN homojunction sandwiched between n GaN template/buffer and p GaN top all on top of ZnO on Silicon.

Several patents and publications briefly mention III-Nitrides as an option for devices along with several other solar cells. None of the following are believed to be EUV /DUV compatible. The following patents and publications mention III-Nitrides but focus on general broad ranges of semiconductors. US 2014/0166079 A1 discloses lateral series connected solar cells of "crystalline semiconductor material" including generic wording of almost all semiconductors. WO 2016/060643 A1 discloses a concentrator solar cell with semiconductor nanocrystals. US 2012/0318324 A1 discloses a laterally arranged multiple bandgap solar cell with dispersive concentrator to provide light to each cell, wherein the solar cells can be bulk or nanowires, and the document discloses many semiconductor materials including InGaN nanowires. US2010/0012168 A1 discloses quantum dot solar cells with nitride films used as an electron conductor. Similarly, US2010/0006143 A1 discloses single and multi-junction quantum dot or quantum well solar cells with III-Nitrides. Similarly, US8529698 B2 discloses nanowire InGaN solar cells grown from gold catalysts on silica substrate. US 2010/0319777 A1 discloses a "CIGS" semiconductor solar cell using the InGaN as only a buffer layer, not an active collector. US 8455756 B2 teaches InGaN on Eu₂O₃ or Sc₂O₃ rare earth oxide substrates for use in a silicon solar cell. US 2012/0180868 A1 describes a III-Nitride flip-chip solar cell with InGaN active regions and GaN tunnel junctions with the incident light entering through back sapphire.

US 2015/0101657 A1 discloses a multi-quantum well solar cell with varying bandgap well regions and with thicknesses varying to achieve current match and mentions "III-V" materials. US 2008/0156366 A1 also discloses a Multi-quantum well nanowire solar cell with varying bandgaps. US 2014/0093995 A1 and US2008/0276989 A1 disclose mechanical stacking of solar cells with large lattice mismatches to reduce effects of defect generation.

US 2015/0380574 A1 does not use the III-Nitrides as the converter materials but instead discloses them to cover many combinations of solar cells to passivate the solar cells with and without ARC and with and without dielectric passivation. Since the III-Nitrides are not the energy converters, they are not compatible with the EUV/DUV. Similarly related patent publication US 2016/0284881 A1 also discloses III-Nitrides for passivation similar to above, but the difference is the III-Nitrides are epitaxially related to the underlying solar cells.

Some patents and publications refer to "Nitrides" but are known in the art to be "dilute nitrides" which have substantially low bandgaps not compatible with the EUV/DUV spectra. These include, for example, US 2012/0174971 A1, which discloses dilute nitrides in phosphide and arsenide multijunction solar cells.

US 2008/0245400 A1 and EP 2400558 A1 disclose further examples of photoelectric conversion devices.

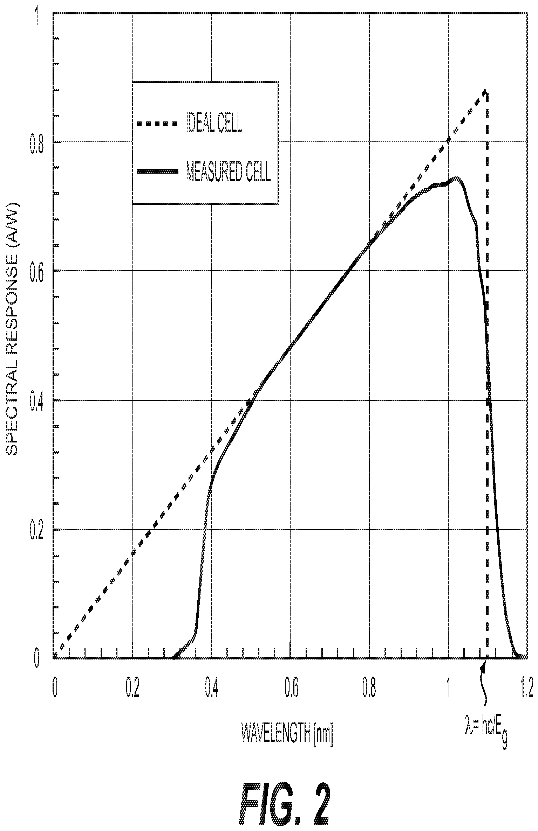

Unlike the traditional solar cell, the EUV/DUV photovoltaic cell of the present disclosure can address several potential challenges. For example, because high energy EUV and DUV light is absorbed so close to the surface of the semiconductor, the influence of the surface is greatly amplified, drastically lowering the conversion efficiency. As shown in Figure 2, the spectral response (amps current per watt of optical input power), a traditional solar cell has almost zero response in the EUV and DUV spectral range. The reasons a traditional solar cell cannot function in the DUV and EUV spectral range include: absorption near the surface resulting in extremely high recombination; absorption in the cover glass and/or transparent conducting layers; and significant loss of energy due to the kinetic energy imparted to the absorbed photocarriers. All of these features are a result of the very high photon energy in the EUV and DUV range.

In an attempt to overcome at least some of the potential challenges associated with the near surface absorption, certain embodiments of the present disclosure eliminate the transparent conducting layer since the layer is not transparent for the EUV and DUV. In the present disclosure, a thin metal layer is utilized to improve the lateral conduction among other benefits. Other embodiments of the present disclosure eliminate the cover glass which will absorb the high energy light, replacing the protective cover glass with a robust material of mechanical integrity greater than glass itself. Further embodiments of the present disclosure shift the built in electric field responsible for charge separation (voltage creation) closer to the surface than typically possible in solar cells. Other embodiments of the present disclosure utilize wide band gap semiconductors that minimize the kinetic energy losses, converting more of the photon's energy into collectable potential energy.

One embodiment of the present disclosure is directed to a photovoltaic device comprising: a base layer of a semiconducting material of a first conductivity type, the base layer having a first energy bandgap; an emitter layer of a semiconducting material of a second conductivity type opposite the first conductivity type disposed over the base layer, the emitter layer having a second energy bandgap; a base electrical contact in electrical communication with the base layer; and an emitter electrical contact in electrical communication with the emitter layer; wherein the first energy bandgap and the second energy bandgap are no less than about 3.2 eV. In a further embodiment, the first energy bandgap and the second energy bandgap are no greater than about 6.2 eV.

In one embodiment, the semiconducting material of the base layer and the semiconductor material of the emitter layer each comprises a semiconductor chosen from Group III nitrides (III-nitrides). In one embodiment, the semiconducting material of the base layer and the semiconducting material of the emitter layer each comprises a semiconductor chosen from AlₓGa₁₋ₓN where (0≤x≤1), SiC, diamond, Ga₂O₃, and ZnO. In one embodiment, the semiconducting material of the base layer and/or the semiconducting material of the emitter layer comprise AlN or GaN.

The base layer and the emitter layer may form a p-n junction region therebetween. In one embodiment, the photovoltaic device further comprises a drift layer of a semiconducting material disposed between the base layer and the emitter layer. The drift layer layer may have a third energy bandgap no less than about 3.2 eV. In one embodiment, the third energy bandgap is no greater than about 6.2 eV. In one embodiment, the semiconducting material of the drift layer comprises a semiconductor chosen from AlₓGa₁₋ₓN where (0≤x≤1), SiC, diamond, Ga₂O₃, and ZnO. In one embodiment, the drift layer is of the first conductivity type. In a further embodiment, the base layer and the drift layer are doped to different concentrations. In another embodiment, the drift layer comprises a two-dimensional sheet of holes.

In one embodiment, the photovoltaic device does not comprise a transparent conducting layer disposed over the emitter layer. The device further comprises a metal layer disposed over the emitter layer, wherein the metal layer is optically transparent in the DUV and/or EUV range in the range from 10 nm to 380 nm. In one embodiment, the metal layer has a thickness less than about 1000 nm. For example, the metal layer may have a thickness less than about 800 nm, less than about 600 nm, less than about 400 nm, less than about 200 nm, less than about 100 nm, less than about 80 nm, less than about 60 nm, less than about 40 nm, less than about 20 nm, less than about 15 nm, less than about 10 nm, less than about 5 nm, or less than about 2 nm. In one embodiment, the metal layer has a thickness in the range of about 1 nm to about 1000 nm, such as about 1 nm to about 800 nm, about 1 nm to about 600 nm, about 1 nm to about 400 nm, about 1 nm to about 200 nm, about 1 nm to about 100 nm, about 1 nm to about 50 nm, about 1 nm to about 25 nm, about 1 nm to about 20 nm, about 1 nm to about 15 nm, about 1 nm to about 10 nm, or about 1 nm to about 5 nm. In one embodiment, the metal layer has a thickness in the range of about 5 nm to about 300 nm, such as about 5 nm to about 100 nm, about 5 nm to about 50 nm, about 5 nm to about 25 nm, or about 5 nm to about 15 nm. In one embodiment, the metal layer has a thickness in the range of about 20 nm to about 50 nm. In one embodiment, the metal layer comprises Al or Mg. In one embodiment, the metal layer comprises collections of nano-dots. In one embodiment, the nano-dots comprise Ni or Au.

As used in the present disclosure, "optically transparent" in the DUV and/or EUV range means that less than 50% of the incident light in the DUV and/or EUV wavelength range passing through the material or layer is absorbed by the material or layer. In some embodiments, less than 40%, less than 30%, less than 20%, less than 10%, or less than 5% of the incident light in the DUV and/or EUV range passing through the material or layer is absorbed by the material or layer.

The combined DUV and EUV wavelength range may be about 380 nm and shorter, such as about 10 nm to about 380 nm. In some embodiments, the range may be about 350 nm and shorter, about 320 nm and shorter, about 280 nm and shorter, about 240 nm and shorter, about 200 nm and shorter, about 150 nm and shorter, about 120 nm and shorter, about 120 nm and shorter, about 80 nm and shorter, about 60 nm and shorter, about 40 nm and shorter, or about 20 nm and shorter. In each of these embodiments, the wavelength may be at least 10 nm, e.g., about 10 nm to about 380 nm, about 10 nm to about 350 nm, or about 10 nm to about 320 nm, about 10 nm to about 280 nm, about 10 nm to about 240 nm, about 10 nm to about 200 nm, about 10 nm to about 80 nm, about 10 nm to about 60 nm, about 50 nm to about 380 nm, about 50 nm to about 350 nm, about 50 nm to about 320 nm, about 50 nm to about 280 nm, about 50 nm to about 240 nm, about 50 nm to about 200 nm, about 50 nm to about 80 nm, about 100 nm to about 380 nm, about 100 nm to about 350 nm, about 100 nm to about 320 nm, about 100 nm to about 280 nm, about 100 nm to about 240 nm, about 100 nm to about 200 nm, about 150 nm to about 380 nm, about 150 nm to about 350 nm, about 150 nm to about 320 nm, about 150 nm to about 280 nm, or about 150 nm to about 240 nm.

In another embodiment, the photovoltaic device does not comprise a protective cover glass. The device is configured such that the semiconducting material of the emitter layer is directly exposed to a DUV and/or EUV optical power source. In another embodiment, the device is configured such that the semiconducting material of the emitter layer is exposed to a DUV and/or EUV optical power source through the metal layer.

In one embodiment, the emitter layer has a thickness less than about 1000 nm. For example, the emitter layer may have a thickness less than about 800 nm, less than about 600 nm, less than about 400 nm, less than about 200 nm, or less than about 100 nm. In any of these embodiments, the emitter layer thickness may be at least about 10 nm, at least about 20 nm, at least about 30 nm, at least about 40 nm, or at least about 50 nm. In one embodiment, the emitter layer has a thickness in the range of about 1 nm to about 1000 nm, such as about 1 nm to about 800 nm, about 1 nm to about 600 nm, about 1 nm to about 400 nm, about 1 nm to about 200 nm, about 1 nm to about 100 nm, or about 1 nm to about 50 nm. In one embodiment, the emitter layer has a thickness in the range of about 5 nm to about 300 nm, such as about 5 nm to about 200 nm, or about 10 nm to about 100 nm. In one embodiment, the emitter layer has a thickness in the range of about 20 nm to about 100 nm, such as about 20 nm to about 75 nm, or about 20 nm to about 50 nm.

In one embodiment, the base layer and the emitter layer are disposed over a substrate. The substrate may be conductive or non-conductive. In certain embodiments, the substrate is a conductive substrate. In other embodiments, the substrate is a non-conductive substrate. In one embodiment, the photovoltaic device further comprises a crystal template disposed between the substrate and the base layer.

In one embodiment, the semiconductor material of the base layer is an n-type GaN material or a p-type GaN material. In another embodiment, the semiconductor material of the base layer is an n-type AlₓGa₁₋ₓN material or a p-type AlₓGa₁₋ₓN material, wherein (0<x<1).

In another embodiment, the present disclosure is directed to a photovoltaic device comprising a base layer of a p-type or n-type semiconducting material having an energy bandgap no less than about 3.2 eV; a metal layer disposed over the base layer, wherein the metal layer is optically transparent in the DUV and/or EUV range in the range from 10 nm to380 nm and forms a Schottky barrier with the semiconducting material of the base layer; a base electrical contact in electrical communication with the base layer; and a top electrical contact in electrical communication with the metal layer.

In one embodiment, the energy bandgap of the p-type or n-type semiconducting material is no greater than about 6.2 eV. In one embodiment, the p-type or n-type semiconducting material comprises a semiconductor chosen from Group III nitrides. In one embodiment, the p-type or n-type semiconducting material comprises a semiconductor chosen from AlₓGa₁₋ₓN where (0≤x≤1), SiC, diamond, Ga₂O₃, and ZnO. In one embodiment, the p-type or n-type semiconducting material comprises AlN or GaN.

In one embodiment, the metal layer that forms a Schottky barrier with the semiconducting material of the base layer has a thickness less than about 1000 nm. For example, the metal layer may have a thickness less than about 800 nm, less than about 600 nm, less than about 400 nm, less than about 200 nm, less than about 100 nm, less than about 80 nm, less than about 60 nm, less than about 40 nm, less than about 20 nm, less than about 15 nm, or less than about 10 nm. In one embodiment, the metal layer has a thickness in the range of about 1 nm to about 1000 nm, such as about 1 nm to about 800 nm, about 1 nm to about 600 nm, about 1 nm to about 400 nm, about 1 nm to about 200 nm, about 1 nm to about 100 nm, about 1 nm to about 50 nm, about 1 nm to about 25 nm, about 1 nm to about 20 nm, about 1 nm to about 15 nm, about 1 nm to about 10 nm, or about 1 nm to about 5 nm. In one embodiment, the metal layer has a thickness in the range of about 5 nm to about 300 nm, such as about 5 nm to about 100 nm, about 5 nm to about 50 nm, about 5 nm to about 25 nm, or about 5 nm to about 15 nm. In one embodiment, the metal layer has a thickness in the range of about 20 nm to about 50 nm. In one embodiment, the metal layer comprises Al or Pt.

In one embodiment, the photovoltaic device further comprises a semiconducting interlayer disposed between the metal layer and the base layer. In one embodiment, the semiconducting interlayer has an energy bandgap no less than about 3.2 eV. In a further embodiment, the energy bandgap is no greater than about 6.2 eV. In one embodiment, the semiconducting interlayer comprises AIN. In one embodiment, the semiconducting interlayer has a thickness less than about 500 nm. For example, the interlayer may have a thickness less than about 300 nm, less than about 200 nm, less than about 100nm, less than about 50 nm, or less than about 25 nm. In any of these embodiments, the interlayer thickness may be at least about 5 nm, about 10 nm, or about 20 nm thick. In one embodiment, the interlayer has a thickness in the range of about 1 nm to about 500 nm, such as about 1 nm to about 300 nm, about 1 nm to about 200 nm, about 1 nm to about 100 nm, about 5 nm to about 75 nm, about 5 nm to about 50 nm, about 5 nm to about 25 nm, or about 5 nm to about 15 nm.

In one embodiment, the base layer comprises an n-type AlₓGa₁₋ₓN, wherein (0≤x≤1). In another embodiment, the base layer comprises an n-type GaN.

In certain embodiments, a SunCell^{®} power system that generates at least one of electrical energy and thermal energy is used, the SunCell^{®} power system comprising at least one vessel capable of a maintaining a pressure of below, at, or above atmospheric; reactants comprising: (i) at least one source of catalyst or a catalyst comprising nascent H₂O, (ii)at least one source of H₂O or H₂O, (iii) at least one source of atomic hydrogen or atomic hydrogen, and (iv) a molten metal; a molten metal injection system comprising at least two molten metal reservoirs each comprising a pump; at least one reactant supply system to replenish reactants that are consumed in a reaction of the reactants to generate at least one of the electrical energy and thermal energy; at least one ignition system comprising a source of electrical power to supply opposite voltages to the at least two molten metal reservoirs each comprising an electromagnetic pump, and at least one power converter or output system of at least one of the light and thermal output to electrical power and/or thermal power.

The molten metal injection system may comprise at least two molten metal reservoirs each comprising an electromagnetic pump to inject streams of the molten metal that intersect inside of the vessel wherein each reservoir may comprise a molten metal level controller comprising an inlet riser tube. The ignition system may comprise a source of electrical power to supply opposite voltages to the at least two molten metal reservoirs each comprising an electromagnetic pump that supplies current and power flow through the intersecting streams of molten metal to cause the reaction of the reactants comprising ignition to form a plasma inside of the vessel. The ignition system may comprise: (i) the source of electrical power to supply opposite voltages to the at least two molten metal reservoirs each comprising an electromagnetic pump and (ii) at least two intersecting streams of molten metal ejected from the at least two molten metal reservoirs each comprising an electromagnetic pump wherein the source of electrical power is capable of delivering a short burst of high-current electrical energy sufficient to cause the reactants to react to form plasma. The source of electrical power to deliver a short burst of high-current electrical energy sufficient to cause the reactants to react to form plasma may comprise at least one supercapacitor. Each electromagnetic pump may comprise one of a (i) DC or AC conduction type comprising a DC or AC current source supplied to the molten metal through electrodes and a source of constant or in-phase alternating vector-crossed magnetic field, or (ii) an induction type comprising a source of alternating magnetic field through a shorted loop of molten metal that induces an alternating current in the metal and a source of in-phase alternating vector-crossed magnetic field. At least one union of the pump and corresponding reservoir or another union between parts comprising the vessel, injection system, and converter may comprise at least one of a wet seal, a flange and gasket seal, an adhesive seal, and a slip nut seal wherein the gasket may comprise carbon. The current of the molten metal ignition system may be in the range of 10 A to 50,000 A. The circuit of the molten metal ignition system may be closed by the intersection of the molten metal streams to cause ignition to further cause an ignition frequency in the range of 0 Hz to 10,000 Hz. The induction-type electromagnetic pump may comprise ceramic channels that form the shorted loop of molten metal.

The power system may further comprise an inductively coupled heater to form the molten metal from the corresponding solid metal wherein the molten metal may comprise at least one of silver, silver-copper alloy, and copper. The power system may further comprise a vacuum pump and at least one chiller. The power system may comprise at least one power converter or output system of the reaction power output such as at least one of the group of a photovoltaic converter and a photoelectronic converter. The reservoirs of the power system may comprise boron nitride, the portion of the vessel that comprises the cell may comprise carbon, and the electromagnetic pump parts in contact with the molten metal may comprise an oxidation resistant metal or ceramic. The hydrino reaction reactants may comprise at least one of methane, carbon monoxide, carbon dioxide, hydrogen, oxygen, and water. The reactants supply may maintain each of the methane, carbon monoxide, carbon dioxide, hydrogen, oxygen, and water at a pressure in the range of 0.01 Torr to 1 Torr. The light emitted by reaction of the reactants of the power system that is directed to the photovoltaic converter may be predominantly DUV and/or EUV radiation. In further embodiments, the photovoltaic cells may comprise concentrator cells that comprise at least one compound chosen from a Group III nitride, GaN, AlN, and GaAlN.

The reactants supply system to replenish the reactants that are consumed in a reaction of the reactants to generate at least one of the electrical energy and thermal energy may comprise at least one gas supplies, a gas housing, a selective gas permeable membrane in the wall of at least one of the reaction vessel and reservoirs, gas partial pressure sensors, flow controllers, at least one valve, and a computer to maintain the gas pressures. In an embodiment, at least one component of the power system may comprise ceramic wherein the ceramic may comprise at least one of a metal oxide, alumina, zirconia, magnesia, hafnia, silicon carbide, zirconium carbide, zirconium diboride, and silicon nitride.

In an embodiment, the PV converter may further comprise a UV window to the PV cells. The PV window may replace at least a portion of the cell wall. The window may be substantially transparent to UV. The window may be resistant to wetting with the molten metal. The window may operate at a temperature that is at least one of above the melting point of the molten metal and above the boiling point of the molten metal. Exemplary windows are sapphire, quartz, MgF₂, and fused silica. The window may be cooled and may comprise a means for cleaning during operation or during maintenance. The SunCell^{®} may further comprise a source of at least one of electric and magnetic fields to confine the plasma in a region that avoids contact with at least one of the window and the PV cells. The source may comprise an electrostatic precipitation system. The source may comprise a magnetic confinement system. The plasma may be confined by gravity wherein at least one of the window and PV cells are at a suitable height about the position of plasma generation.

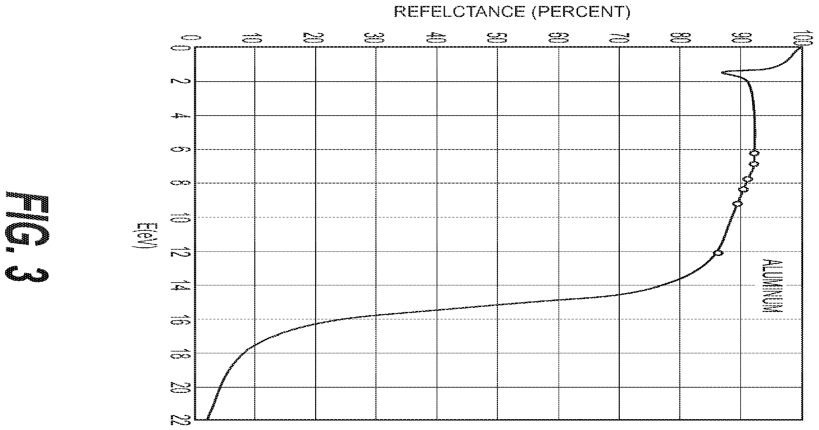

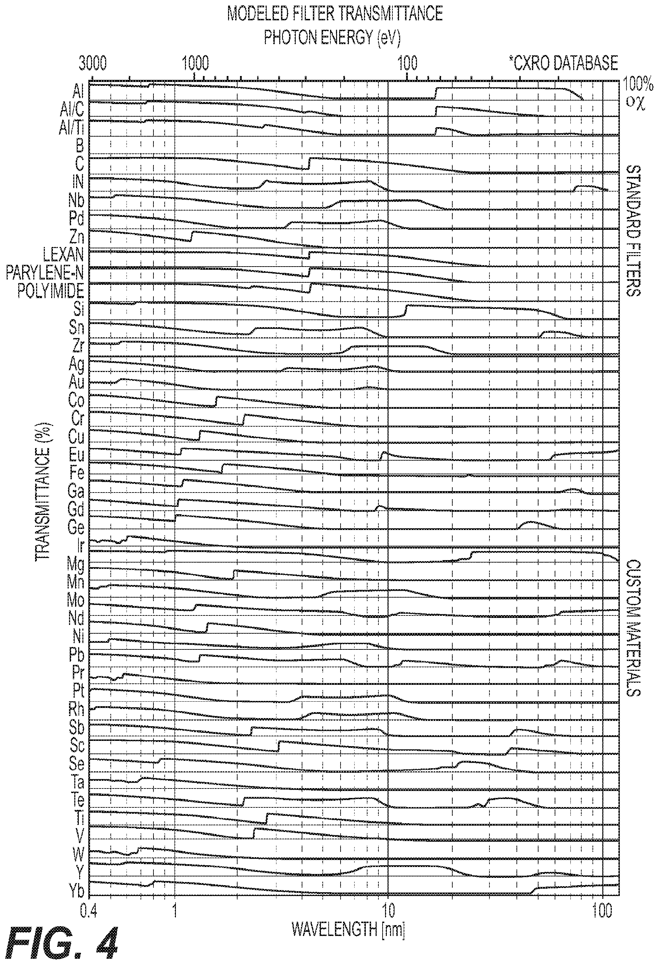

In certain embodiments of the present disclosure, the Transparent Conducting Layer (TCL) is eliminated because these layers have very small diffusion lengths and when combined with photon energies for which the absorption is near the surface, minimal if any photons make it to the photovoltaic semiconductor, and instead are being absorbed in the TCL. While the TCL is typically a semiconductor of large bandgap, in a traditional solar cell it does not contribute to the photocurrent. When used in a EUV/DUV photovoltaic cell, the same TCL absorbs the high energy photons but has no collecting junction to allow charge separation. Thus the electrons and holes simply recombine resulting in thermalization power loss. Some embodiments of the present disclosure eliminate the TCL, and other embodiments replace the semiconductor TCL with the thin metal, as discussed above, that is optically transparent in the DUV and/or EUV range in the range from 10 nm to 380 nm. Figure 3 shows a typical reflectance spectra of a 300 nm thick layer of aluminum which indicates a transparency window for photons above about 15 eV (wavelengths less than ~82 nm). Figure 4 shows a range of metals and their corresponding transmission characteristics which confirms the data from Figure 3 and further indicates the transmission window for aluminum is about 82 nm to about 15 nm, covering the entire EUV spectral range for the source shown in Figure 1. Generally any metal that has an adequate transmission window in Figure 4 can be used in a EUV PV cell as a metallic current spreading layer, effectively replacing the TCL as used in a traditional solar cell. In certain embodiments, aluminum and magnesium can be used. Aluminum also has many additional advantages as outlined below.

Since the EUV and DUV sources are not ever present outside of controlled environments, there is no need for a protective cover glass to prevent rain, hail or similar environmental damage. In certain embodiments, the present invention eliminates the cover glass, replacing it with a semiconductor directly exposed to the EUV /DUV light source and/or exposed through a metal current spreading layer as described above. In certain embodiments, the devices of the present disclosure use extremely hard semiconductors such as GaN, AlN, AlGaN (AlGaN indicates a shorthand notation denoting an alloy of the binary compounds GaN and AlN at any variation in ratio of the two binaries), SiC, diamond, ZnO, Ga₂O₃ or similar materials known to those in the art. The high energy photons of the EUV and DUV light are absorbed in the robust semiconductors instead of being wasted in the cover glass.

To avoid the recombination resulting from the EUV and DUV photons being absorbed so close to the illuminated surface, all embodiments of the present disclosure use wide bandgap semiconductors to increase the absorption depth. Other embodiments of the present disclosure address the same issue by moving the collecting electric field close to the illuminated surface. Some embodiments of the present invention use p-n junctions to create the internal electric field using narrow emitter regions (the emitter is the top cathode or anode layer exposed to the light source) to minimize the light absorbed near the defective surface. Still other embodiments replace the p-n junctions with Schottky junctions that utilize the transparent metals described above in a dual role as current spreading layers to improve lateral conduction and also to establish an electric field that peaks at (or near when the image force lowering effect is considered) the metal-semiconductor junction.

Certain embodiments of the present discosure utilize wide band gap semiconductors that minimize the kinetic energy losses, converting more of the photon's energy into collectable potential energy. When the photon energy is greater than the bandgap of the semiconductor, the excess energy above the energy bandgap is lost to thermalization (kinetic energy that cannot be collected as power). For this reason, the semiconductor used to convert the photon should be of nearly equal bandgap energy as the photon being converted to power. As shown in Figure 1, the power in the DUV range for a prototypical DUV /EUV source increases for energies greater than approximately 3.2 eV. This sets a lower limit on the optimal energy bandgaps to be used in the photovoltaic cells of the present disclosure. Excessive thermalization losses can occur with an energy bandgap lower than approximately 3.2 eV. In practice, the larger the energy bandgap, the more difficult the semiconductor is to dope, an important feature to make the semiconductor conductive. Without adequate doping the PV cell is too resistive, resulting in excessive power losses. Additionally a higher bandgap than the minimum 3.2 eV energy can result in transmission losses for photon energies below the bandgap. Thus, there is a practical upper limit for the energy bandgap. Given the limitations in doping wide bandgap semiconductors and considering the transmission losses for the spectrum shown in Figure 1, certain embodiments of the present disclosure are directed to an optimal energy bandgap in the range of approximately 3.2-6.2 eV.

As described above, the present disclosure is directed to the application of the photovoltaic power conversion principle to a novel source, an extreme and/or deep UV optical power source. This is done by selecting wide and ultra-wide bandgap semiconductor materials that, while optimal for the efficient potential energy extraction with minimal kinetic energy losses for the EUV and DUV ranges, are practically useless for traditional solar cells. These selected materials are robust enough that the cover glass protective layers normally found with solar cells can be removed and conductive enough that either by themselves or with a thin metal layer added have sufficient lateral conductivity such that EUV/DUV absorbing transparent conductive semiconductor layers are not used.

There are several embodiments of present disclosure that can share common design themes:
a) Use of wide and ultra-wide bandgap semiconductors that are transparent to the visible and IR solar spectrum, but that efficiently absorb and convert the EUV and DUV power sources;
b) The placement of the charge separating electric fields within nanometers or tens of nanometers from the illuminated surface, thus minimizing the losses associated with the near surface absorption inherent to the EUV /DUV photons;
c) Use of semiconductors that by themselves are robust enough so as to facilitate the elimination of absorbing cover glasses; and
d) Elimination of the absorbing semiconducting lateral conducting layers that block the EUV /DUV light from reaching the converting semiconductor layers.

While Molecular Beam Epitaxy (MBE) was used for all the epitaxial device structures set forth in the examples below, Metal Organic Chemical Vapor Epitaxy (MOCVD), Hydride and/or Halide Vapor Phase Epitaxy (HVPE) or any other manufacturing technique well known in the art can be used for the production of the structures disclosed herein. In some instances, MOCVD templates of GaN or HVPE templates of AlN were used as a base crystal seed layer for the MBE growth of the device structures.

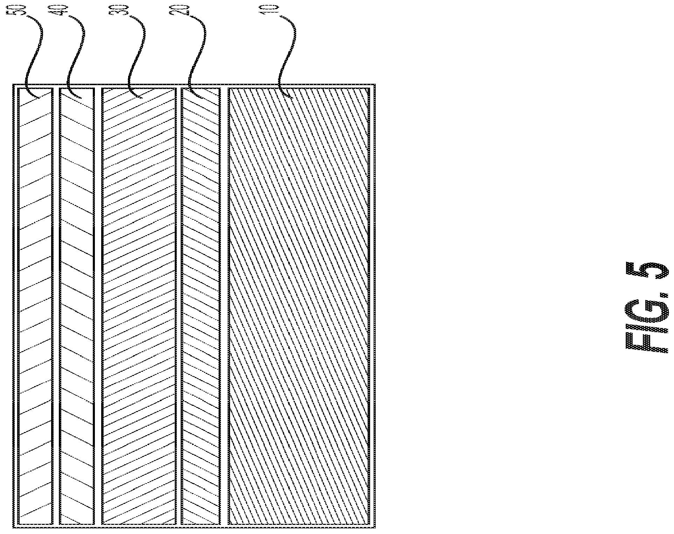

An exemplary but non-restricting basic EUV/DUV PV cell device structure is shown in Figure 5. Depicted is a sequence of semiconductor layers 20-50 grown by one of the above or similar techniques known in the art on a 10 substrate. Layer 20 is a crystal template consisting of any number of semiconductor layers (not shown) well known in the art and intended to create a high quality semiconductor. For example, 20 may be a single layer of GaN grown with varied temperature and flux characteristics or a superlattice of many layers of alternating lattice constant. In any case, 20 is grown in such a way known in the art to reduce the defect density to a level suitable for electrical devices. Layer 30 is the base of the EUV/DUV PV cell. In some embodiments the 30 base is an n-type layer while in other embodiments this 30 base is a p-type layer. In some embodiments this 30 base is GaN, AlN or AlₓGa₁₋xN, where (0<x<l). In all embodiments, this 30 base layer is conductive and is to be used as either an anode or cathode in the EUV /DUV PV cell. In some embodiments this 30 base layer is also the contact layer on which the metal electrodes are attached.

Layer 40 is what is known in the art to be a drift layer or a layer that contains the electric field that separates the electrons from the holes, driving the holes toward the anode and the electrons toward the cathode. Drift layer 40 may be an explicitly grown layer, such as a layer where the doping or material composition is changed from that in the 30 base layer or the drift layer 40 may be a region where the electric field is non-zero but is not specifically engineered differently from that of the base or emitter. In other words, the drift layer 40 may result as a consequence of the 30 base layer and the 50 emitter layer or may have specific doping and composition variations from those in the 30 base layer and the 50 emitter. One of the major advances of devices of the present disclosure is to place the drift layer 40 as close to the illuminated surface as possible without degrading the device electrical integrity. In one embodiment, the drift layer 40 contains not only the non-zero electric field but also contains a two dimensional sheet of holes.

Layer 50 is the EUV/DUV PV cell emitter. As used herein, the emitter is named according to the traditional solar cell convention that says the emitter is the layer closest to the illumination surface (or may contain the illumination surface). This nomenclature is in contrast to the electrical designation that the emitter is the source of majority carriers in forward bias. In some embodiments 50 emitter is an n-type layer while in other embodiments layer 50 is a p-type layer. In some embodiments, the emitter 50 is a GaN layer while in others it is AlGaN. Still in other Schottky diode embodiments the emitter is a metal.

The devices of the present disclosure can be fabricated from the grown layer stack 10-50 via several well known methods in the art including plasma etching, photolithography, and metallization.

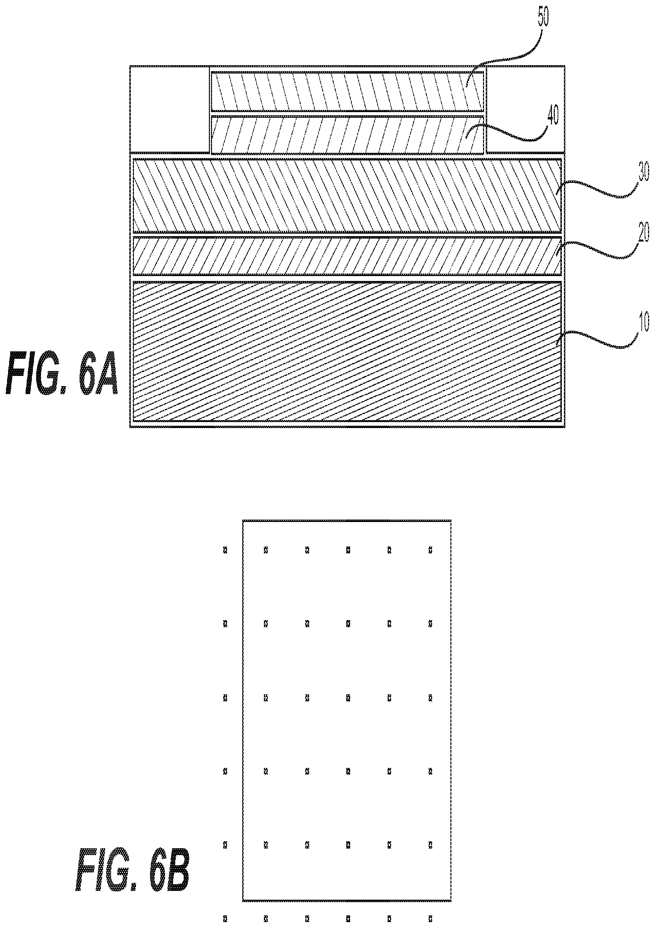

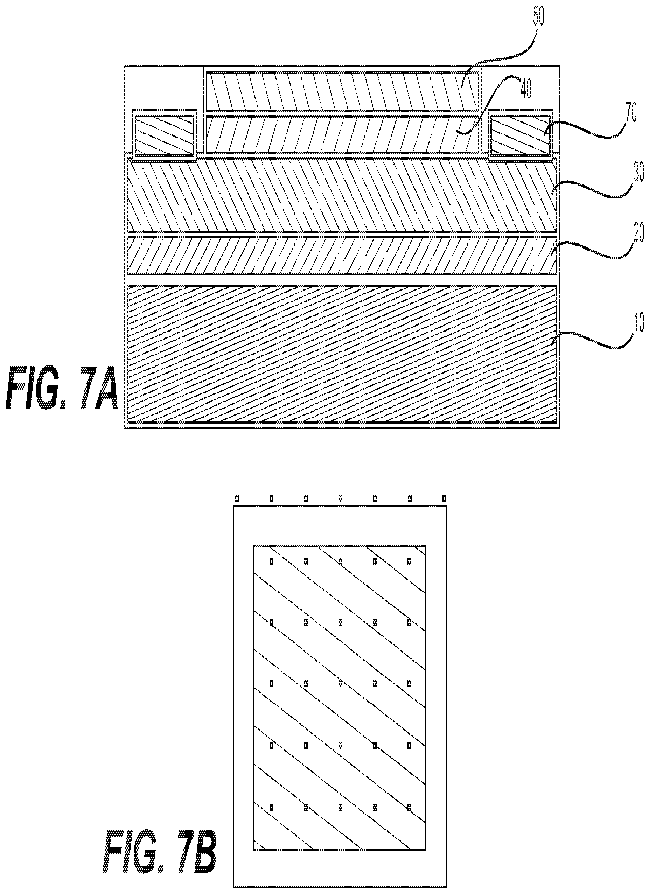

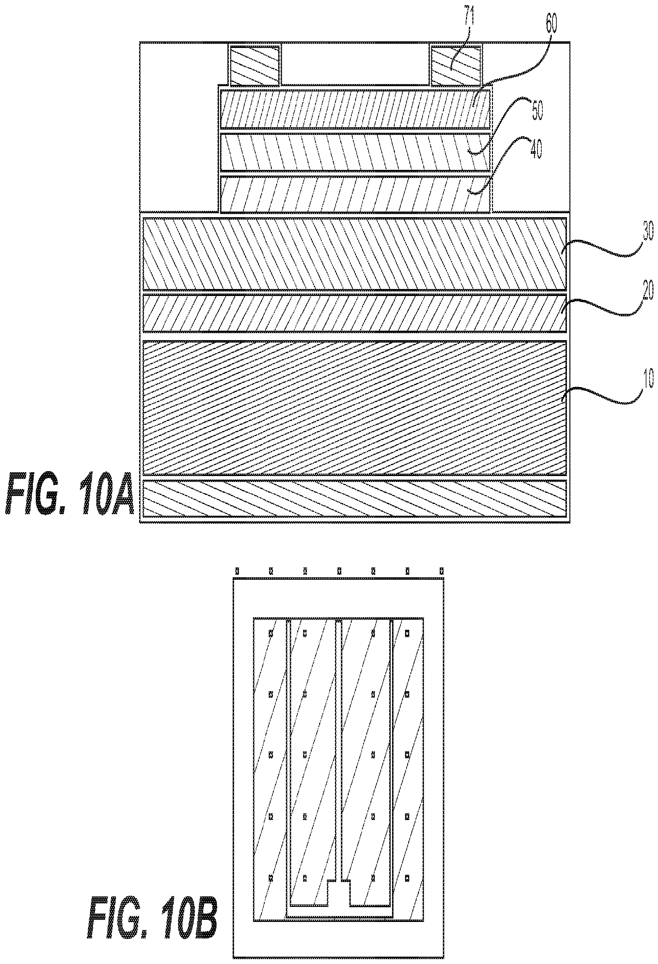

Figure 6A shows a cross section of a EUV/DUV PV cell after the first etching step exposes the base. Figure 6B is the top view from the CAD mask program indicating the mesa structure etched down to expose the 30 base. This step exposes the base should it be needed to add metallization (see options in Figures 7 and 10) and electrically isolates the junction from other devices on the wafer.

Figure 7A shows a cross section of the EUV /DUV PV cell after the 70 base metallization is added to contact the 30 base for embodiments that use a non-conducting substrate. Figure 6B is the top view from the CAD mask program showing the added 70 base metallization contact structure connected to the 30 base for embodiments that use a non-conducting substrate.

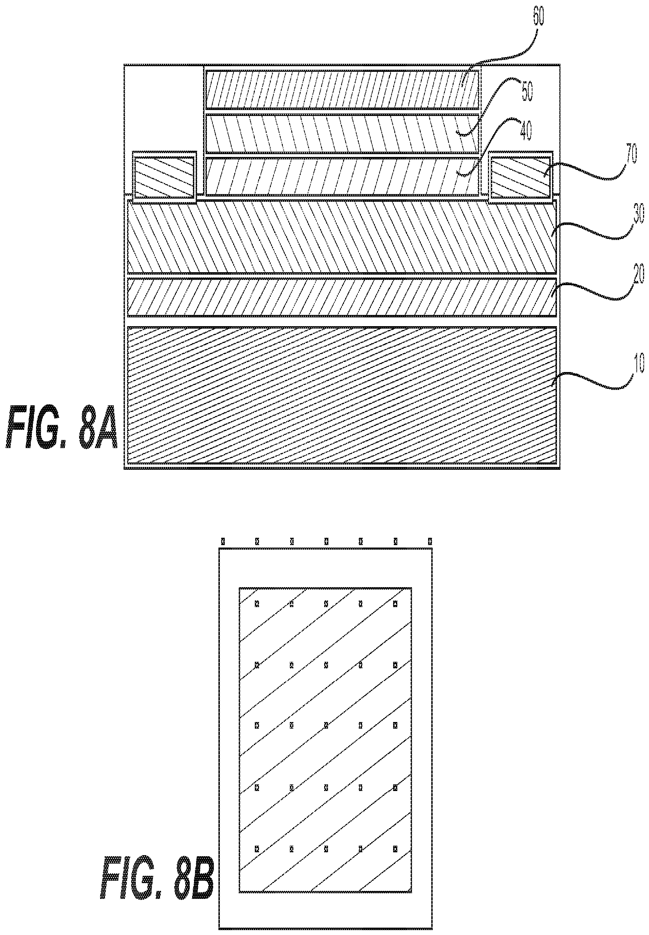

Figure 8A shows a cross section of the EUV/DUV PV cell after the 60 optional current spreading layer is added to the 50 emitter using photolithography, metallization and thermal annealing. Figure 8B is the top view from the CAD mask program indicating the 60 optional current spreading layer on the 50 emitter structure. Due to the specific physics involving EUV/DUV light absorption in the near surface region, specific planar thin EUV/DUV transparent metals such as Al and Mg can be used for the current spreading layer. Alternatively, metals that agglomerate into collections of nano-dots on the surface such as Ni/Au can be used without significant loss of transmission. In these agglomerated metal systems, it is well known in the art that the nano-dots aid conduction via percolation surface currents wherein current flows from dot to emitter to dot while the inter-dot regions remain uncovered by the metal and thus, optically transparent.

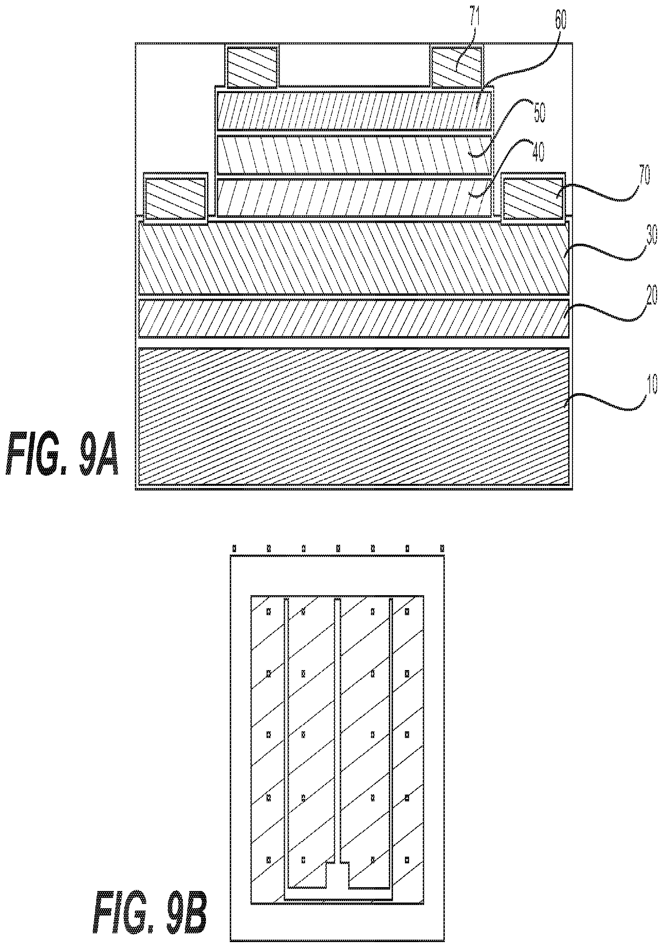

Figure 9A shows a cross section of the EUV/DUV PV cell after the 71 emitter metallization is added to either the 50 emitter (not pictured) or 60 the current spreading layer. Figure 9B is the top view from the CAD mask program indicating the mesa structure after the 71 emitter metallization is added to either the 50 emitter (not pictured) or 60 the current spreading layer. The 71 emitter metallization is arranged in a standard grid line connected to buss bar arrangement as well known in the art.

Figure 10A shows a cross section of the finished EUV/DUV PV cell in the embodiments that use a conductive substrate. Figure 6B is the top view from the CAD mask program indicating the mesa structure in the embodiments that use a conductive substrate. In these embodiments the 72 base metallization is on the back side of the substrate and the prior 70 topside base metallization is not used. This configuration has the advantage of lower illumination shadow loss and larger optically active area.

The following are examples of non-limiting embodiments according to the present disclosure. For example, one skilled in the art will recognize that many other semiconductors including but not limited to SiC, diamond, Ga₂O₃, ZnO and others can be used for similar structures as described below.

### Exemplary Embodiment 1. Shallow emitter GaN n-base p-n Diode

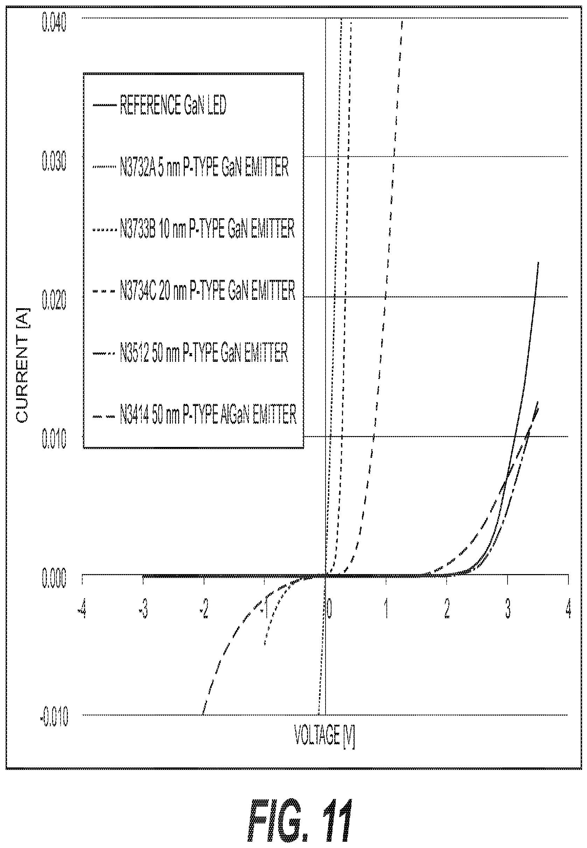

The most widely available and least expensive wide bandgap semiconductor that meets the criteria of energy bandgap above approximately 3.2 eV is GaN with a bandgap of approximately 3.4 eV. Owing to the quality of n-type GaN being substantially better than p-type material and the base access resistance of n-type base structures being substantially lower for laterally contacted devices (devices grown on non-conducting substrates like sapphire) the overwhelming majority of GaN p-n junctions produced today are n-type base/p-type emitter (emitter being the illuminated side) configurations. In other words, anode illuminated devices. Several thicknesses of p-type emitters grown on the same n-type base ranging from 5-50 nm emitters were examined electrically. Ideally, the p-type emitter should be as thin as possible to put the electric field between the p and n layers that separates electron-hole pairs as close to the surface where absorption occurs. In practice, it was found that a practical lower limit for the emitter thickness existed of about 50 nm both because below a lower limit, the diode quality became poor due to direct current tunneling from the contact to n-ₜype base and due to increases in the lateral resistance in the thin p-type emitter causing a "soft" or resistive rectifying current voltage characteristic as shown in Figure 11. The advantages of this type of p-type emitter p-n junction include simple design and inexpensive availability by a variety of established manufacturing methods.

### Exemplary Embodiment 2. Shallow emitter GaN p-base p-n Diode

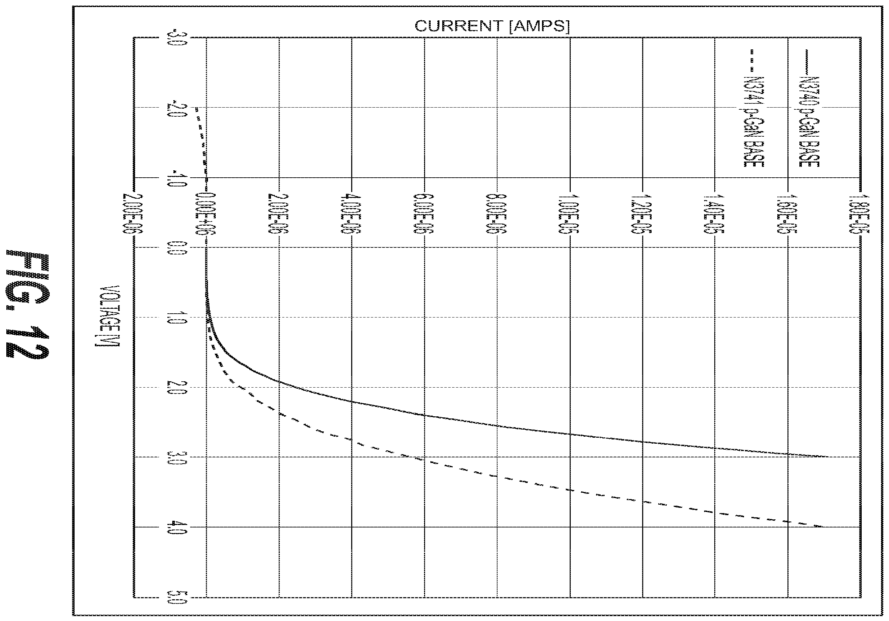

The majority of semiconductors have higher mobility for electrons than holes. GaN is no exception. Thus, a second exemplary embodiment of the present invention is a p-type base (inverted) structure that has an n-type emitter exposed to the illumination. In bench IV tests with a solar lamp (with the improper spectrum for testing due to the limited UV and no DUV/EUV photons) these structures produced the highest voltage of any EUV/DUV PV device. However, the current-voltage characteristic of the diodes was substantially more resistive owing to the higher base access resistance as shown in figure 12 that is 100 times lower current than those in Figure 11.

### Exemplary Embodiment 3. AlGaN p-n Diode

Exemplary embodiment 3 is a similar structure to embodiment 1 shown in Figure 9 but instead of GaN, AlₓGa₁₋ₓN is used. Techniques like MBE have been shown to produce exceptional p-type material even at high Aluminum compositions that MOCVD has struggled to produce. As such, p-n diodes of reasonable quality can be produced with bandgaps much higher than GaN alone. Thus, AlₓGa₁₋ₓN can theoretically produce higher voltages than GaN alone. A complication is that AlₓGa₁₋ₓN is lattice mismatched from GaN and AlN and since presently, only AlN or GaN substrates are the only substrates available for epitaxy, AlₓGa₁₋ₓN PV cells inherently have dislocations and defects in higher concentration than GaN alone. Thus, someof the expected performance increases are lost with increased recombination. Figure 11 shows that even for a small 3% aluminum mole fraction, the DC diode characteristics begin to degrade compared to those with no Al.

### Exemplary Embodiment 4.

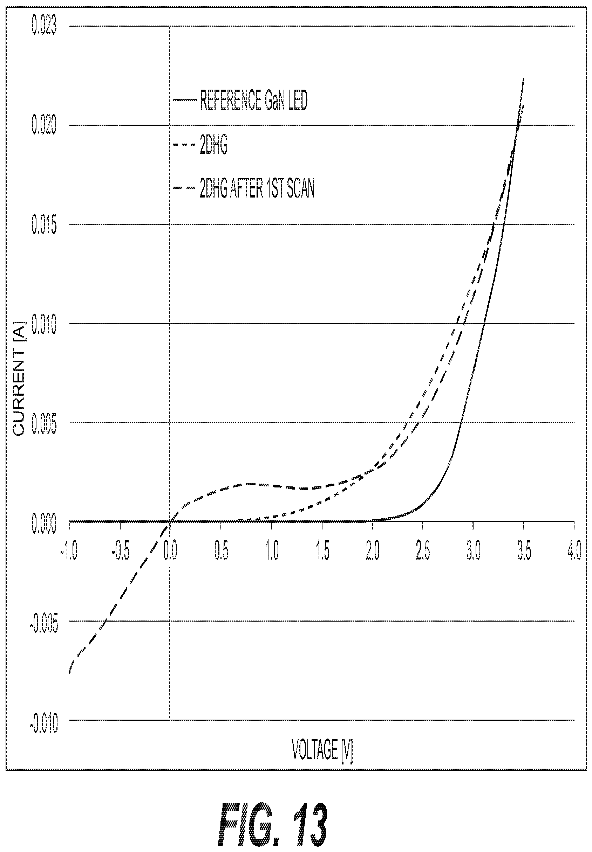

Another exemplary embodiment involves creating an ultra-thin layer of holes that acts to enhance the lateral conduction of the thin emitter layer used to absorb the EUV and DUV photons. As an example, a n-type AlGaN base with a two dimensional hole gas (2DHG, a 2 dimensional layer of holes) created by a polarization discontinuity between the AlGaN and a p-type GaN emitter is used. The use of a 2DHG enhanced p-n heterojunction diode allows for a higher lateral conduction layer using the 2D sheet of holes. Figure 13 shows a DC current voltage characteristic of an n-type AlGaN base/2DHG/p-type GaN emitter 2DHG enhanced p-n heterostructure diode. Differences in the current-voltage response were observed on subsequent scans with scans after the first scan showing clear negative differential resistance.

### Exemplary Embodiment 5.

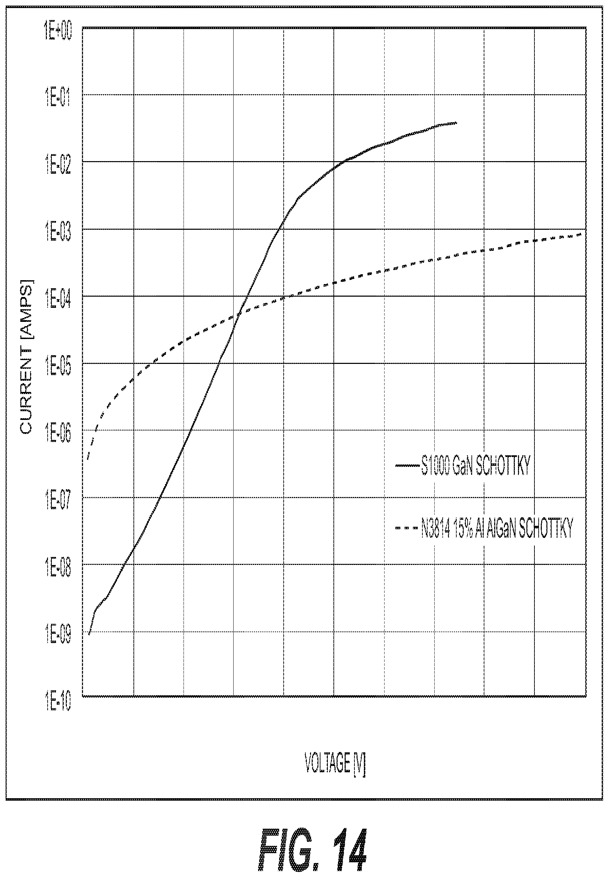

Exemplary embodiment 5 is a (Al)GaN Schottky diode that uses an ultra-shallow electric field created by a transparent metal Schottky barrier on an n-type (Al)GaN base. In this structure the Schottky barrier metal replaces the emitter and is extremely thin and optically transparent to the EUV/DUV light. The full metal coverage also aids the lateral current spreading reducing the series resistance losses. Figure 14 shows a comparison of Schottky diodes produced with x=0% and 15% aluminum. Figure 14 shows the log of the current versus voltage showing a near perfect relationship with a single exponential for GaN but significantly compromised series resistance for an Al mole fraction of 15%. When the Schottky metal is aluminum, the aluminum can be applied in situ directly after the MBE growth of the semiconductors assuring a clean high quality Schottky diode.

### Exemplary Embodiment 6.

The sixth exemplary embodiment uses an ultra-shallow electric field created by a transparent metal Schottky barrier on an n-type (Al)GaN base but adds an AlN ultra-wide bandgap layer between the metal and the semiconductor base. This advanced Schottky diode structure lowers the leakage current of the structure (which increases the photovoltage) and provides for a wider bandgap absorbing layer near the front illuminated surface, more optimally converting the high energy photons. This structure consisting of an aluminum metal Schottky barrier, a 10 nm thin ultra-wide bandgap AlN interlayer and an-type GaN base resulted in the highest photovoltage of any device tested.

Other variations of the embodiments disclosed above include the use of a conducting substrate. Conducting substrates such as Si, SiC, Diamond, Ga₂O₃, graphene, ZnO or similar conducting substrates known to those in the art can be used with any of the prior or similar embodiments. This conducting substrate implementation allows a lower base access resistance and thus, higher performance. This is particularly useful for the p-base variations such as Exemplary Embodiment 3.

### EXAMPLES

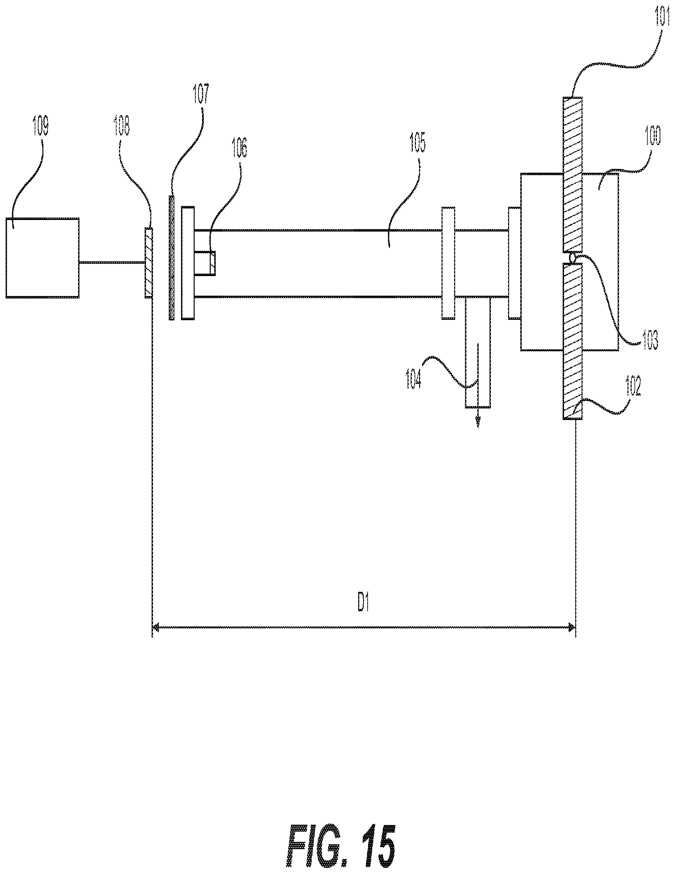

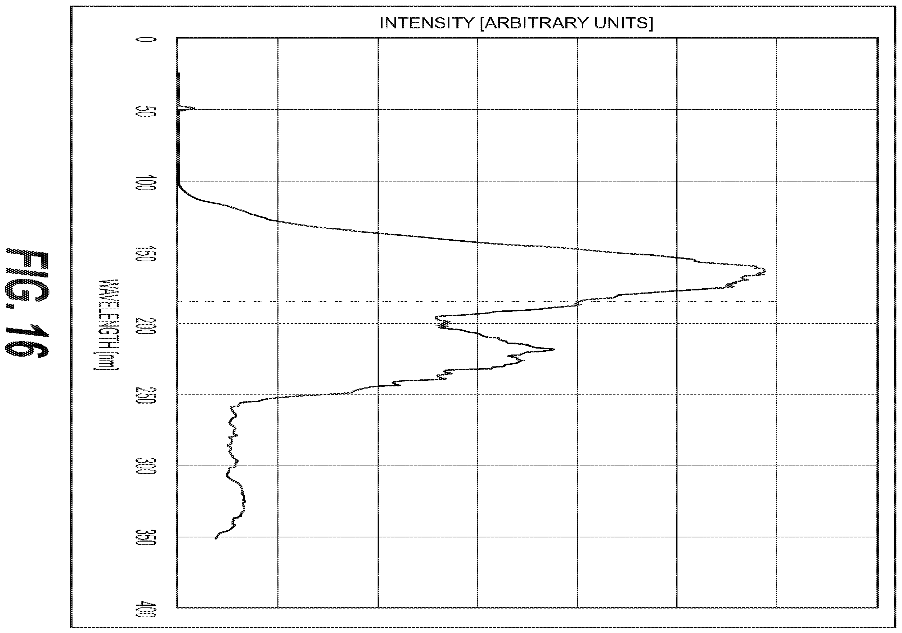

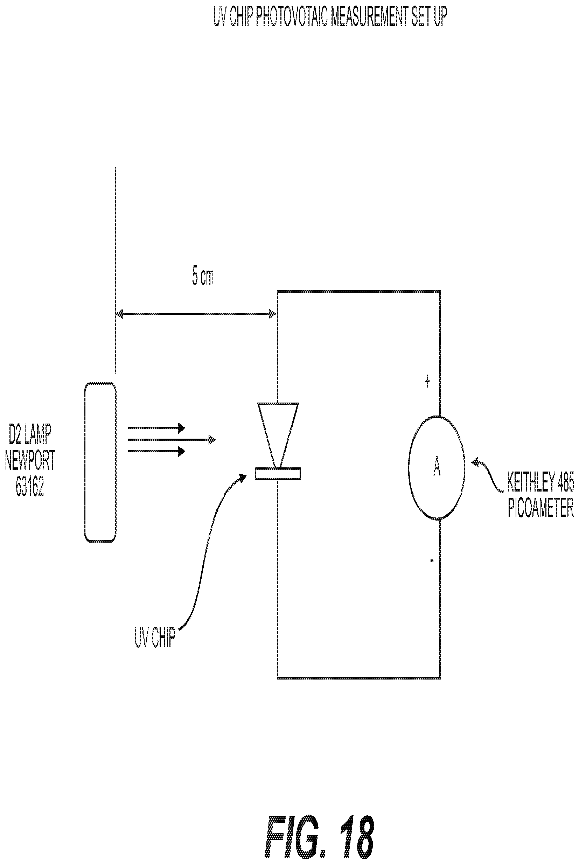

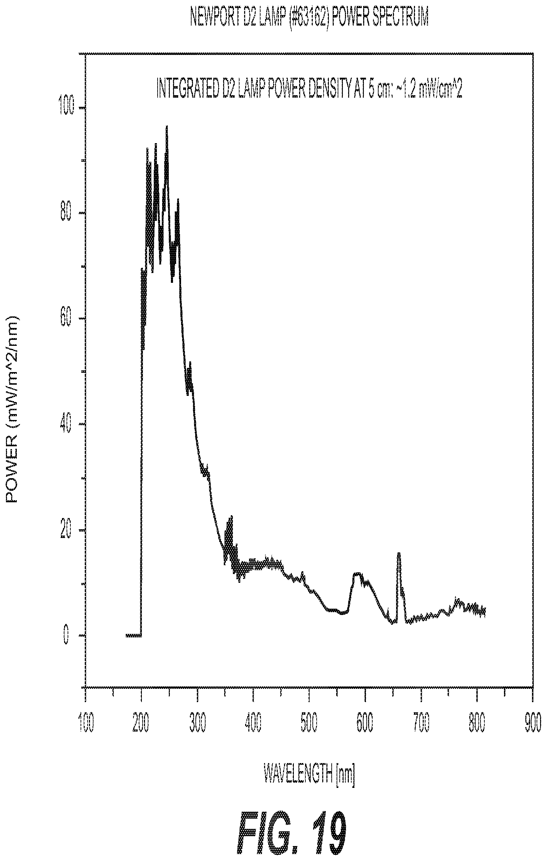

To demonstrate advantages of the present disclosure, two light sources were used to simulate the anticipated spectral powers: 1) Brilliant Light Power's SunCell^{®} was used to generate a transient DUV spectrum that simulates the continuous wave spectrum shown in Figure 1; and 2) a deuterium DUV lamp was also used for simplicity although its spectral content is distributed to lower than optimal for the cells demonstrated herein which were designed for the EUV spectral range. These two light sources are described in more detail below.
1) Brilliant Light Power's SunCell^{®}: As described in Figure 15, the SunCell^{®} power cell consists of a high current spot welder (not shown) connected to copper electrodes 101 and 102 inside a vacuum chamber 100. A silver fuel pellet was made by dripping molten silver into water to form a small silver ball. The silver ball weighs about 80 mg, diameter of about 1.5 ~2.0 mm. 103 is in contact with electrodes 101 and 102. When electrodes 101 and 102 are energized by the spot welder with about 30,000 amps of current, the fuel pellet 103 is detonated creating a momentary (transient) DUV spectra as represented in Figure 16. Since the vacuum chamber 100 and delivery tube 105 is evacuated by vacuum pump 104 to about 10 millitorr, minimal DUV absorption occurs allowing the DUV light to escape an MgF₂ DUV transparent window 106. Since the fuel vaporization also creates visible and infrared light that can skew the tests, some tests use a HOYA UV(0) filter 107 to reject all UV light and allow measurement of the response to visible and infrared light from the source. The EUV/DUV PV cell is placed beyond the MgF₂ window 107 in the path of the transient DUV light. A Pico 54428 digital oscilloscope 109 records the transient photo-induced voltage generated by the EUV/DUV PV cell. As a reference one of the best UV photodiodes available on the market, a UV Enhanced Hamamatsu photodiode (model 55973 Silicon PIN) was used to compare traditional solar cells. This photodiode represents a UV enhanced photo cell operated in unbiased photovoltaic, solar cell, mode and thus is the best response a traditional solar cell can produce. Given the nature of the light source is transient, the time evolution of the spectral content is not known but the average spectral content is described by Figure 16 and shows substantially deeper wavelengths than any commercial lamp.
   Transient voltages were obtained from the SunCell^{®} power cell with all values quoted being the peak voltage measured. However, transient photocurrents are much harder to obtain, requiring rapid response, sensitive current amplifiers that are not readily available. Thus, to estimate the current response, a second constant flux, non-optimal spectral content lamp was used.
2) Deuterium DUV lamp: Photocurrent was simulated by a very weak constant flux deuterium lamp positioned approximately 5 cm from the EUV/DUV photovoltaic device as shown in Figure 18. The lamp used in all tests was a Newport model 63162 and the photocurrent was measured with a Keithley 485 picoammeter. The estimated integrated intensity of the lamp was approximately 1.2 mW/cm² and has a spectral power distribution as shown in Figure 19. Given all the cells tested were designed to be operated with a EUV spectrum similar to Figure 1, performance under the EUV deficient deuterium lamp was found to be less than when using the SunCell^{®} light source.

**Example 1:** The EUV/DUV PV cell used for this SunCell^{®} test was sample N3741 10-11 and is representative of Examplary Embodiment 2. It consisted of a 3 µm n-type MOCVD template on which a thick 500 nm p-GaN layer doped to 10¹⁸ cm⁻³ hole concentration using MME growth technology with a 2:1 metal to nitrogen stoichiometry. This was followed by a 60 nm grade from 10¹⁸ cm⁻³ hole concentration to 2×10⁹ cm⁻³ hole concentration by grading the MME stoichiometry to 1.2:1 stoichiometry. Using this condition, a 250 nm p+ GaN layer was grown followed by a 12 nm n+ Germanium doped (10¹⁹ cm⁻³ electron concentration) GaN emitter. The device used standard Ti/Al/Ti/Au n-type top gridded contact well known in the art with no spreading layer. The p-type contact was standard Ni/Au also well known in the art.

A reference Hamamatsu silicon photodiode generated 0.68 Volts without HOYO filter 107 and 0.67 Volts with the HOYO UV cut off filter 107 indicating a mere 0.01 volts due to the UV light.

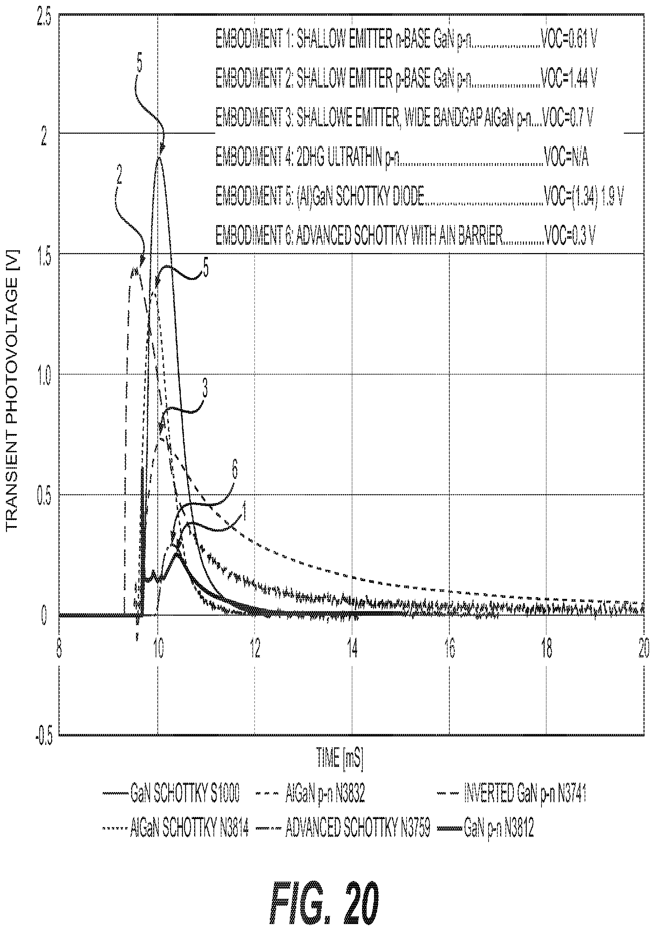

Contrarily, EUV/DUV PV cell N3741 produced 0.46 ± 0.01 Volts without the filter and 0.075 ± 0.025 Volts with the UV cut off filter 107. This indicates that unlike the silicon reference solar cell device, the major contribution to the signal in EUV/DUV PV Cell was due to UV light. This indicates that the N3741 10-11 EUV/DUV PV cell produced approximately 0.385 volts due to the DUV content with shorter wavelengths than 400 nm. The EUV/DUV PV cell can be placed in vacuum so as to avoid the significant air absorption of the DUV light as indicated by the region to the left of the line at 185 nm in Figure 16. When placed in vacuum, this same EUV/DUV PV cell produced a staggering 1.44 volts as shown in Figure 20 which is approximately double the voltage possible from a traditional silicon solar cell.

The same device tested with the deuterium lamp produced 92 nA photocurrent for a 500 x 500 µm area, or 0.37 A/m² even though the optical power is only approximately 1.2 mW/cm ², or about 1% of the power a visible solar cell would receive on earth (100 mW/cm² for AM1.5).

**Example 2:** The EUV/DUV PV cell used for this SunCell^{®} test was sample S1000 and is representative of Examplary Embodiment 5. S1000 was a 4 µm GaN layer doped at 10¹⁷ cm-3 n-type GaN and used a 10 nm Pt layer that functioned as both the current spreading and Schottky Layer with a 10 nm Pt/400 nm Au grid to provide external contact. As shown in Figure 20, when placed in vacuum, this EUV/DUV PV cell produced 1.9 Volts as shown which is approximately 270% of the voltage possible from a traditional silicon solar cell.

**Example 3:** The EUV/DUV PV cell used for this SunCell^{®} test was sample N3814 and is representative of Exemplary Embodiment 5 using AlGaN instead of GaN as in Example 2. The AlGaN was 100 nm n-type (approximately 2×10¹⁸ cm⁻³) Al_{0.15}Ga_{0.85}N grown by MME with approximately a 1.2:1 stoichiometry and used a 10 nm Pt layer that functioned as both the current spreading and Schottky layer with a 10 nm Pt/400 nm Au grid to provide external contact. As shown in Figure 20, when placed in vacuum, this EUV /DUV PV cell produced 1.34 Volts as shown which is approximately 200% of the voltage possible from a silicon solar cell.

**Example 4:** The EUV/DUV PV cell used for this SunCell^{®} test was sample N3832 and is representative of Exemplary Embodiment 1. The device was 3-5 µm n-type GaN substrate, 500 nm MME grown n-GaN 2:1 stoichiometry and a 50 nm compositional grade to Al_{0.15}Ga_{0.85}N using 1.2:1 stoichiometry followed by a 50 nm n- (approximately 10¹⁷ cm⁻³) Al_{0.15}Ga_{0.35}N (1.2:1 stoichiometry) layer and a 50 nm undoped Al_{0.15}Ga_{0.85}N (1.2:1 Stoichiometry) layer and a 50 nm p+ Al_{0.15}Ga_{0.85}N. The device used standard Ti/Al/Ti/Au n-type contacts well known in the art. The p-type contact was standard Ni/Au also well known in the art. As shown in Figure 20, when placed in vacuum, this EUV/DUV PV cell produced 0.7 Volts as shown which is approximately 100% of the voltage possible from a traditional silicon solar cell.

This same device when tested under the deuterium lamp produced 43 nA photocurrent for a 750 x 750 µm area, or 0.076 A/m².

**Example 5:** The EUV/DUV PV cell used for the SunCell^{®} test was sample N3832 and is representative of Examplary Embodiment 1. The device was 3-5 µm n-type GaN substrate, 200 nm MME grown n-type (approximately 10¹⁸ cm⁻³) GaN 2:1 stoichiometry and a 50 nm unintentionally doped GaN using 2:1 stoichiometry followed by a 50 nm p-type (approximately 10¹⁹ cm⁻³) GaN (1.2:1 stoichiometry) layer. The device used standard Ti/Al/Ti/Au n-type contacts well known in the art. The p-type contact was standard Ni/Au also well known in the art. As shown in Figure 20, when placed in vacuum, this EUV/DUV PV cell produced an unusual transient photovoltage which had a peak of approximately 0.61 volt as shown in Figure 20 followed by a sharp decay and a sustained approximately 0.25 volt normally decaying signal. At present, this behavior is unexplained but is likely due to the tunneling of carriers complications resulting from having such shallow emitters. This was a dynamic phenomenon associated with the transient illumination and was not observed in the deuterium lamp constant flux tests.

This same device when tested under the deuterium lamp produced 49 nA photocurrent for a 750 x 750 µm area, or 0.087 A/m².

## Claims

1. A photovoltaic (PV) device, comprising:
a base layer of a semiconducting material of a first conductivity type, the base layer having a first energy bandgap;
an emitter layer of a semiconducting material of a second conductivity type opposite the first conductivity type disposed over the base layer, the emitter layer having a second energy bandgap;
a base electrical contact in electrical communication with the base layer; and an emitter electrical contact in electrical communication with the emitter layer; and
a metal layer disposed over the emitter layer,
wherein the first energy bandgap and the second energy bandgap are no less than 3.2 eV,
**characterised in that**
the metal layer is optically transparent in the wavelength range from 10 nm to 380 nm, and the device is configured such that the semiconducting material of the emitter layer is exposed to an extreme ultra-violet (EUV) and/or deep ultra-violet (DUV) optical power source through the metal layer;

2. The PV device of claim 1, wherein the first energy bandgap and the second energy bandgap are no greater than 6.2 eV.

3. The PV device of claim 1 or 2, wherein the semiconducting material of the base layer and the semiconductor material of the emitter layer each comprises a semiconductor chosen from III-Nitrides.

4. The PV device of claim 1, wherein the semiconducting material of the base layer and the semiconducting material of the emitter layer each comprises a semiconductor chosen from AlₓGa₁₋ₓN where (0≤x≤1), SiC, diamond, Ga₂O₃, and ZnO.

5. The PV device of claim 1, wherein the semiconducting material of the base layer and/or the semiconducting material of the emitter layer comprises AIN or GaN.

6. The PV device of claim 1, wherein the emitter layer has a thickness in the range of 20 nm to 100 nm.

7. The PV device of claim 1, wherein the semiconductor material of the base layer is an n-type GaN material or a p-type GaN material.

8. The PV device of claim 1, wherein the semiconductor material of the base layer is an n-type AlₓGa₁₋ₓN material or a p-type AlₓGa₁₋ₓN material, wherein (0<x<1).

## Patentansprüche

1. Photovoltaische (PV) Vorrichtung, umfassend:
eine Basisschicht aus einem halbleitenden Material eines ersten Leitfähigkeitstyps, wobei die Basisschicht eine erste Energiebandlücke aufweist;
eine Emitterschicht aus einem halbleitenden Material eines zweiten Leitfähigkeitstyps, entgegengesetzt zum ersten Leitfähigkeitstyp, die über der Basisschicht angeordnet ist, wobei die Emitterschicht eine zweite Energiebandlücke aufweist;
einen elektrischen Basiskontakt in elektrischer Verbindung mit der Basisschicht; und einen elektrischen Emitterkontakt in elektrischer Verbindung mit der Emitterschicht; und
eine Metallschicht, die über der Emitterschicht angeordnet ist, wobei die erste Energiebandlücke und die zweite Energiebandlücke nicht weniger als 3,2 eV betragen,
**dadurch gekennzeichnet, dass**
die Metallschicht im Wellenlängenbereich von 10 nm bis 380 nm optisch transparent ist und die Vorrichtung ausgestaltet ist, um das halbleitende Material der Emitterschicht durch die Metallschicht einer optischen Energiequelle für extremes Ultraviolett (EUV) und/oder tiefes Ultraviolett (DUV) auszusetzen.

2. PV-Vorrichtung nach Anspruch 1, wobei die erste Energiebandlücke und die zweite Energiebandlücke nicht mehr als 6,2 eV betragen.

3. PV-Vorrichtung nach Anspruch 1 oder 2, wobei das halbleitende Material der Basisschicht und das halbleitende Material der Emitterschicht jeweils einen Halbleiter umfassen, der aus III-Nitriden ausgewählt ist.

4. PV-Vorrichtung nach Anspruch 1, wobei das halbleitende Material der Basisschicht und das halbleitende Material der Emitterschicht jeweils einen Halbleiter umfassen, der aus AlₓGa₁₋ₓN, wobei (0 ≤ x ≤l), SiC, Diamant, Ga₂O₃ und ZnO ausgewählt ist.

5. PV-Vorrichtung nach Anspruch 1, wobei das halbleitende Material der Basisschicht und/oder das halbleitende Material der Emitterschicht AIN oder GaN umfasst.

6. PV-Vorrichtung nach Anspruch 1, wobei die Emitterschicht eine Dicke im Bereich von 20 nm bis 100 nm hat.

7. PV-Vorrichtung nach Anspruch 1, wobei das halbleitende Material der Basisschicht ein GaN-Material vom n-Typ oder ein GaN-Material vom p-Typ ist.

8. PV-Vorrichtung nach Anspruch 1, wobei das halbleitende Material der Basisschicht ein AlₓGa₁₋ₓN-Material n-Typ oder ein AlₓGa₁₋ₓN-Material vom p-Typ ist, wobei (0 < x < 1).

## Revendications

1. Dispositif photovoltaïque (PV) comprenant:
une couche de base en matériau semiconducteur ayant un premier type de conductivité, la couche de base ayant une première bande d'énergie interdite;
une couche d'émetteur en matériau semiconducteur ayant un second type de conductivité, opposé au premier type de conductivité, disposée sur la couche de base, la couche d'émetteur ayant une deuxième bande d'énergie interdite;
un contact électrique de base en communication électrique avec la couche de base, et un contact électrique d'émetteur en communication électrique avec la couche d'émetteur; et
une couche de métal disposée sur la couche d'émetteur, dans lequel la première bande d'énergie interdite et la deuxième bande d'énergie interdite ne sont pas inférieures à 3,2 eV,
**caractérisé en ce que**
la couche de métal est optiquement transparente dans la gamme de longueurs d'onde de 10 nm à 380 nm, et le dispositif est configuré de telle manière que le matériau semiconducteur de la couche d'émetteur est exposé à une source de puissance optique d'ultraviolet extrême (EUV) et/ou d'ultraviolet profond (DUV).

2. Dispositif photovoltaïque selon la revendication 1, dans lequel la première bande d'énergie interdite et la deuxième bande d'énergie interdite ne sont pas supérieures à 6,2 eV.

3. Dispositif photovoltaïque selon la revendication 1 ou 2, dans lequel le matériau semiconducteur de la couche de base et le matériau semiconducteur de la couche d'émetteur comprennent chacun un semiconducteur choisi parmi les nitrures du groupe III.

4. Dispositif photovoltaïque selon la revendication 1, dans lequel le matériau semiconducteur de la couche de base et le matériau semiconducteur de la couche d'émetteur comprennent chacun un semiconducteur choisi parmi les AlₓGa₁₋ₓN où (0 ≤ x ≤1 ), SiC, le diamant, Ga₂O₃ et ZnO.

5. Dispositif photovoltaïque selon la revendication 1, dans lequel le matériau semiconducteur de la couche de base et/ou le matériau semiconducteur de la couche d'émetteur comprennent AIN ou GaN.

6. Dispositif photovoltaïque selon la revendication 1, dans lequel la couche d'émetteur a une épaisseur comprise dans l'intervalle de 20 nm à 100 nm.

7. Dispositif photovoltaïque selon la revendication 1, dans lequel le matériau semiconducteur de la couche de base est un matériau GaN de type N ou un matériau GaN de type P.

8. Dispositif photovoltaïque selon la revendication 1, dans lequel le matériau semiconducteur de la couche de base est un matériau AlₓGa₁₋ₓN de type N ou un matériau AlₓGa₁₋ₓN de type P, dans lequel (0 < x < 1).
